# DEMANDE DE BREVET EUROPEEN

(11) **EP 3 343 365 A1**
(43) Date de publication de la demande: **04.07.2018**
(21) Numéro de dépôt: 17210999.3
(22) Date de dépôt: 28.12.2017
(51) Int. Cl.: G06F 9/455, G06F 9/50

(54) **PROCEDE DE STOCKAGE DE DONNEES DANS UN SYSTEME DE STOCKAGE VIRTUALISE**

(30) Priorité: 28.12.2016 FR 1663488
(71) Demandeur: Bull SAS, 78340 Les Clayes-sous-Bois (FR)
(72) Inventeur: BONNEL, Thierry, 95220 HERBLAY (FR); VALLEE, Florence, 75015 PARIS (FR); DEJON, Christian, 75012 PARIS (FR); BLEUZE, Patrice, 78380 BOUGIVAL (FR)
(74) Mandataire: Cabinet Plasseraud

(57) **Abrégé**

L'invention concerne un procédé de stockage de données d'une application (1) s'exécutant en machine virtuelle, dans un système de stockage virtualisé (2) correspondant à l'émulation d'au moins une bande magnétique et d'au moins un lecteur de bandes magnétiques associé, par l'intermédiaire d'un protocole d'échange de données (4, 5) qui est TCP/IP.

## Description

### DOMAINE DE L'INVENTION

L'invention concerne le domaine des procédés de stockage d'une application s'exécutant en machine virtuelle gérée par un hyperviseur de virtualisation, dans un système de stockage virtualisé. L'invention concerne également les machines virtuelles et les systèmes de stockage virtualisés qui sont associés à ces procédés de stockage.

### CONTEXTE DE L'INVENTION

L'invention concerne notamment le domaine des procédés de stockage pour des applications qui d'une part présentent une valeur importante pour leurs utilisateurs et nécessitent donc de pouvoir être conserver durablement et qui d'autre part sont souvent volumineuses, complexes et difficiles à moderniser surtout longtemps après leur conception.

Il est cependant possible de faire tourner ces applications sans modification notable en environnement virtualisé lequel leur permet d'une part de fonctionner avec une grande longévité et d'autre part de continuer à fonctionner pour un coût et une complexité de maintenance qui restent très limités.

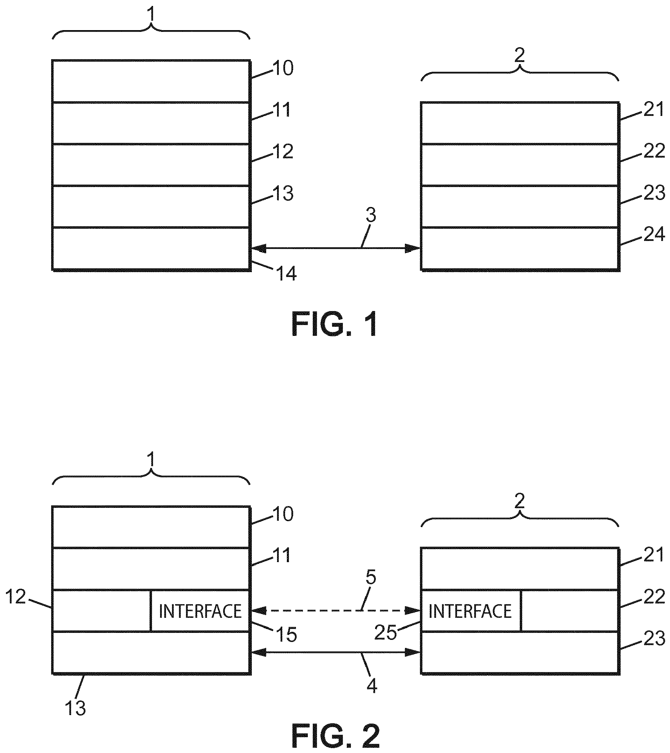

Selon un premier art antérieur, par exemple décrit à la figure 1, il est connu un procédé de stockage d'une application s'exécutant en machine virtuelle gérée par un hyperviseur de virtualisation, dans un système de stockage virtualisé qui est supporté par cet hyperviseur de virtualisation.

Dans ce premier art antérieur, l'application et le système de stockage virtualisé échangent les données par l'intermédiaire d'un protocole d'échanges de données au niveau d'une liaison de type connexion fibre (« Fibre Channel » en langue anglaise) qui est particulièrement bien adapté au stockage de données.

En revanche, lorsqu'un système de stockage virtualisé est partiellement supporté par l'hyperviseur de virtualisation, l'échange de données au niveau d'une liaison de type connexion fibre reste possible mais il est dégradé et certaines fonctionnalités usuelles ne sont plus possibles, certaines d'entre elles pouvant toutefois être utiles voire nécessaires pour l'application considérée.

Par exemple, l'utilisation de lecteurs de bandes par une application s'exécutant sur une machine virtuelle dans un environnement virtualisé est soumise à des contraintes particulières ayant pour conséquence de n'être généralement pas supportée par les hyperviseurs de virtualisation.

Pour les systèmes de stockage virtualisés, comme les lecteurs de bandes, qui ne sont généralement pas supportés, ou au moins pas complétement supportés, par les hyperviseurs de virtualisation, certaines solutions sont connues mais elles entraînent toutes un fonctionnement dégradé dû à des pertes de fonctionnalité usuelle nécessaires ou au moins utiles.

Selon un deuxième art antérieur, il est connu de pouvoir parfois établir un lien entre une machine virtuelle et un système de stockage virtualisé dans un mode de fonctionnement de court-circuit (« Passthrough » en langue anglaise). Ce mode de connexion directe d'une machine virtuelle à un périphérique de stockage virtualisé court-circuite l'hyperviseur de virtualisation. Ce mode de court-circuit induit des pertes de fonctionnalités au niveau de la haute disponibilité et des sauvegardes dynamiques des données stockées, ce qui le rend moins intéressant, voire incompatible dans le cadre d'une utilisation par des applications critiques et sécurisées, comme par exemple le stockage de données médicales confidentielles pour des usagers d'un système de santé devant archiver et maintenir opérationnelles son archive pendant de nombreuses années.

Dans un troisième art antérieur potentiel, il pourrait être envisagé d'utiliser le protocole d'échange de données iSCSI (« Internet Small Computer Interface » en langue anglaise), mais les mêmes restrictions d'utilisation des lecteurs de bandes s'appliqueraient pour certains hyperviseurs.

Dans un quatrième art antérieur potentiel, il pourrait être envisagé d'utiliser le protocole d'échange de données FCoE (« Fibre Channel over Ethernet » en langue anglaise), mais les mêmes restrictions d'utilisation des lecteurs de bandes s'appliqueraient pour certains hyperviseurs.

### RESUME DE L'INVENTION

Le but de la présente invention est de fournir un procédé de stockage de données palliant au moins partiellement les inconvénients précités.

Plus particulièrement, l'invention vise à fournir un procédé de stockage d'une application s'exécutant en machine virtuelle gérée par un hyperviseur de virtualisation dans un système de stockage virtualisé au moins partiellement non supporté par cet hyperviseur de virtualisation, par un protocole d'échanges de données à un niveau supérieur, le niveau réseau, qui soit quant à lui supporté par cet hyperviseur de virtualisation et qui ne soit pas un protocole d'échanges de données dédié au stockage de données.

L'invention propose un protocole d'échange de données qui réalise une sorte d'encapsulation du dispositif de stockage virtualisé de manière à le rendre transparent pour l'hyperviseur de virtualisation lequel ne voyant plus la spécificité incompatible (au moins partiellement) du dispositif de stockage va accepter de le supporter complètement.

Pour cela, l'invention va réaliser une sorte d'encapsulation et de décapsulation des messages en provenance et à destination du dispositif de stockage virtualisé avant de les envoyer par ou les recevoir de la part de l'hyperviseur de virtualisation, par l'intermédiaire d'un protocole d'échange de données au niveau réseau. Le système de stockage virtualisé va présenter une interface modifiée pour réaliser cette encapsulation / décapsulation au niveau stockage, tandis que l'application va également présenter une interface modifiée pour réaliser symétriquement cette encapsulation / décapsulation au niveau application, ce qui est une façon élégante de contourner l'incompatibilité (totale, ou au moins partielle) entre l'hyperviseur de virtualisation et le système de stockage virtualisé.

A cette fin, la présente invention propose un procédé de stockage de données d'une application s'exécutant en machine virtuelle gérée par un hyperviseur de virtualisation, dans un système de stockage virtualisé correspondant à l'émulation d'au moins un dispositif de stockage au moins partiellement non supporté par l'hyperviseur de virtualisation, par l'intermédiaire d'un protocole d'échange de données au niveau réseau qui d'une part n'est pas dédié au stockage de données et qui d'autre part est supporté par l'hyperviseur de virtualisation.

A cette fin, la présente invention propose aussi une machine virtuelle gérée par un hyperviseur de virtualisation, comprenant une interface machine codée de manière d'une part à envoyer des commandes de stockage de données d'une application s'exécutant sur cette machine virtuelle et d'autre part à recevoir des réponses à ces commandes de la part d'un système de stockage virtualisé correspondant à l'émulation d'au moins un dispositif de stockage au moins partiellement non supporté par l'hyperviseur de virtualisation, par l'intermédiaire d'un protocole d'échange de données au niveau réseau qui d'une part n'est pas dédié au stockage de données et qui d'autre part est supporté par l'hyperviseur de virtualisation.

A cette fin, la présente invention propose également un système de stockage virtualisé correspondant à l'émulation d'au moins un dispositif de stockage au moins partiellement non supporté par un hyperviseur de virtualisation, comprenant une interface stockage codée de manière d'une part à recevoir des commandes de stockage de données d'une application s'exécutant sur une machine virtuelle gérée par cet hyperviseur de virtualisation et d'autre part à envoyer des réponses à ces commandes, par l'intermédiaire d'un protocole d'échange de données au niveau réseau qui d'une part n'est pas dédié au stockage de données et qui d'autre part est supporté par cet hyperviseur de virtualisation.

Dans le cas où le système de stockage virtualisé est l'émulation d'au moins une bande magnétique et d'au moins un lecteur de bandes magnétiques associé, le protocole d'échange de données est TCP/IP (« Transport Control Protocol / Internet Protocol » en langue anglaise). Ce protocole d'échange de données est TCP/IP, universellement connu, n'est évidemment pas un protocole dédié au stockage de données bien qu'il soit largement utilisé aujourd'hui dans ce contexte.

Dans ce cas, la présente invention propose un procédé de stockage de données d'une application s'exécutant en machine virtuelle, dans un système de stockage virtualisé correspondant à l'émulation d'au moins une bande magnétique et d'au moins un lecteur de bandes magnétiques associé, par l'intermédiaire d'un protocole d'échange de données qui est TCP/IP.

Dans ce cas, la présente invention propose aussi une machine virtuelle comprenant une interface machine codée de manière d'une part à envoyer des commandes de stockage de données d'une application s'exécutant sur cette machine virtuelle et d'autre part à recevoir des réponses à ces commandes de la part d'une émulation d'au moins une bande magnétique et d'au moins un lecteur de bandes magnétiques associé, par l'intermédiaire d'un protocole d'échange de données au niveau réseau qui est TCP/IP.

Dans ce cas, la présente invention propose également un système de stockage virtualisé correspondant à l'émulation d'au moins une bande magnétique et d'au moins un lecteur de bandes magnétiques associé, non supporté par un hyperviseur de virtualisation, comprenant une interface stockage codée de manière d'une part à recevoir des commandes de stockage de données d'une application s'exécutant sur une machine virtuelle gérée par cet hyperviseur de virtualisation et d'autre part à envoyer des réponses à ces commandes, par l'intermédiaire d'un protocole d'échange de données au niveau réseau qui est TCP/IP.

Dans ce cas, dans des modes de réalisation préférentiels de l'invention, le procédé de stockage permet d'accéder aux données sur bandes dans un environnement virtualisé, en se basant sur un protocole de communication TCP/IP entre l'application s'exécutant sur une machine virtuelle et la bibliothèque de bandes de stockage virtuelles. La connexion de la bande virtuelle sur la connexion fibre n'est supportée qu'avec des contraintes d'utilisation par certains hyperviseurs. Dans cet environnement virtuel, le protocole SCSI (« Small Computer Interface » en langue anglaise), supporté par la liaison de communication de type connexion fibre est remplacé par un protocole TCP/IP situé lui au niveau réseau, au niveau du point de communication de l'application (« Socket application level » en langue anglaise). Les commandes SCSI sont encapsulées dans des trames IP. Ainsi le protocole TCP/IP permet alors indirectement d'envoyer et de recevoir des commandes et des réponses SCSI, lesquelles n'auraient pas pu être envoyées et reçues directement en raison de l'opposition de l'hyperviseur de virtualisation.

Suivant des modes de réalisation préférés, l'invention comprend une ou plusieurs des caractéristiques suivantes qui peuvent être utilisées séparément ou en combinaison partielle entre elles ou en combinaison totale entre elles, avec l'un et/ou l'autre des objets de l'invention précités.

Préférentiellement, l'utilisation de ces systèmes de stockage par les applications a été programmée en langage COBOL. Leur adaptation directe serait complexe et coûteuse. Il est plus simple et plus efficace de virtualiser ces systèmes de stockage qui sont préférentiellement des bandes.

Les bandes sont des mémoires à accès séquentiel, comme les bandes magnétiques classiques. Certaines fonctionnalités sont spécifiques à ces bandes. Chaque bande doit préférentiellement pouvoir notamment être montée et démontée dans le système de stockage. Sur chaque bande, l'accès des données est séquentiel. Par conséquent, la bande doit préférentiellement pouvoir être rembobinée, et elle doit aussi préférentiellement pouvoir se positionner à un endroit précis (en étant déroulée jusqu'à cet endroit précis).

De préférence, le dispositif de stockage émulé comprend l'émulation d'une ou de plusieurs mémoires à accès séquentiel pour la lecture et pour l'écriture. Ce type de mémoire comprend des fonctionnalités spécifiques lesquelles sont souvent non supportées par les hyperviseurs de virtualisation, rendant donc l'utilisation de l'invention particulièrement intéressante.

De préférence, le dispositif de stockage émulé comprend l'émulation d'une ou de plusieurs mémoires amovibles. Ainsi, non seulement un dispositif de stockage élémentaire, mais aussi une bibliothèque de plusieurs voire de nombreux dispositifs de stockage élémentaires, éventuellement identiques ou similaires entre eux, vont pouvoir être émulés. Ainsi, par exemple non seulement une bande, mais aussi une bibliothèque de plusieurs voire de nombreuses bandes, vont pouvoir être émulées.

De préférence, le dispositif de stockage émulé comprend l'émulation d'au moins une bande magnétique et d'au moins un lecteur de bandes magnétiques associé. Ce type de mémoire comprend des fonctionnalités spécifiques lesquelles sont souvent non supportées par les hyperviseurs de virtualisation, rendant donc l'utilisation de l'invention particulièrement intéressante.

De préférence, le protocole d'échange de données au niveau réseau est TCP/IP. C'est un protocole très connu et largement utilisé, il est parfaitement compatible avec les hyperviseurs de virtualisation, et il permet d'encapsuler et de décapsuler facilement et efficacement les commandes et les réponses de systèmes de stockage virtualisés, en particulier des bandes de stockage.

De préférence, le protocole de communication TCP/IP transporte des commandes SCSI et leurs réponses. Les commandes SCSI et leurs réponses sont utilisées dans certains systèmes de stockage comme par exemple les bandes de stockage. Un nouveau protocole réseau TCP/IP est avantageusement défini au niveau de l'interface logicielle « Socket » en modèle client-serveur. Les messages échangés simulent alors l'envoi de commandes SCSI et la réception de leur réponse. Les commandes SCSI et leurs réponses sont avantageusement encapsulées dans des trames IP.

De préférence, le dispositif de stockage émulé écoute les requêtes de la ou des applications au niveau d'un point de communication défini par l'association d'une adresse IP et d'un numéro de port. Ainsi, il peut traiter les requêtes de différentes applications clientes, mais il doit toutefois les traiter dans leur ordre d'arrivée. En fait, chaque lecteur émulé est accessible via une paire constituée d'une adresse IP et d'un numéro de port. Pour chaque adresse IP, plusieurs lecteurs de bandes peuvent être émulés. Pour un serveur de stockage, plusieurs adresses IP peuvent être configurées. Les échanges se font sur réseau Ethernet/IP. Un lecteur de bande est décrit par un couple <IP><port#>. Le lecteur de bande virtuel crée un point de communication de type Socket sur lequel il écoute les requêtes des différents clients potentiels. Un logiciel pilote (« driver » en langue anglaise) de lecteur virtuel n'étant pas partageable, c'est la première application cliente se connectant qui accède au lecteur jusqu'à terminaison initiée par cette application cliente. Le lien Socket ouvert est bidirectionnel. Il permet à une application de transmettre ses requêtes et les données associées, et au système de stockage virtualisé d'envoyer les réponses aux requêtes et les données associées. Le protocole est synchrone, le système de stockage ne traite une requête qu'après avoir envoyé la réponse à la requête précédente.

De préférence, l'application est une application critique sécurisée requérant une sauvegarde dynamique. Ainsi, l'utilisation de l'invention est particulièrement intéressante dans la mesure, où même lorsque les hyperviseurs de virtualisation sont suffisamment évolués pour offrir un support au moins partiel de n'importe quel système de stockage virtualisé, ces hyperviseurs de virtualisation n'offrent cependant pas de fonctionnalité de sauvegarde dynamique.

De préférence, la gestion du dispositif de stockage émulé lui-même est effectuée à l'aide d'un protocole de communication qui d'une part est différent du protocole d'échange de données au niveau réseau et d'autre part n'est pas dédié au stockage de données.

Ce système de stockage virtualisé fournit une émulation de lecteur de bandes offrant un protocole de communication réseau, préférentiellement TCP/IP, et non plus de type connexion fibre. Le chemin de données est donc changé pour utiliser le mode de connexion réseau. En revanche, le chemin de commandes, gérant les demandes de montage et démontage des bandes, demeure inchangé car il est indépendant de la liaison de type connexion fibre.

De préférence, la machine virtuelle est basée sur la virtualisation d'un système d'exploitation propriétaire. L'utilisation de l'invention est d'autant plus intéressante que la mise à jour et l'évolution d'un tel système d'exploitation propriétaire est plus difficile et plus délicate, il faut en effet avoir accès à des informations propriétaires lesquelles sont par définition moins accessibles voire pas accessibles.

De préférence, l'hyperviseur de virtualisation est un hyperviseur de virtualisation « VMware ».

De préférence, le moteur du système de stockage virtualisé s'exécute sur une plateforme « AIX ».

De préférence, le système de stockage virtualisé comprend un serveur associé à une grappe de disques et à un logiciel d'émulation de l'espace disque de la grappe de disques en au moins une bande magnétique virtuelle et en au moins un lecteur de bandes magnétiques associé virtuel, et préférentiellement en plusieurs bandes magnétiques virtuelles et en un ou plusieurs lecteurs de bandes magnétiques associés virtuels. Ainsi, un bon compromis est réalisé entre d'une part cet ancien système de bandes magnétiques peu évolutif qu'il n'est alors plus nécessaire de faire évoluer et dont les données qui y sont stockées peuvent être gardées telles quelles dans leur structure et d'autre part le nouveau système de stockage technologique performant qui peut être utilisé sans nécessiter de restructurer les données à y stocker.

L'application accède à des bandes de stockage par l'intermédiaire d'un système de stockage virtualisé. Ce système de stockage virtualisé comporte un serveur, une grappe de disques et un logiciel capable d'émuler cet espace disque en bandes magnétiques de stockage. Dans cet environnement virtualisé de l'application, le système de stockage est modifié au niveau de son interface pour s'adapter au nouveau protocole de communication réseau.

De préférence, le lecteur de bandes magnétiques virtuel est un lecteur « LTO5 HP ». En fait, le système de stockage virtualisé émule des lecteurs de bande, de type « LTO5 HP », qui sont les lecteurs supportés par certaines applications existantes très volumineuses.

D'autres caractéristiques et avantages de l'invention apparaîtront à la lecture de la description qui suit d'un mode de réalisation préféré de l'invention, donnée à titre d'exemple et en référence aux dessins annexés.

### BREVE DESCRIPTION DES DESSINS

La figure 1 représente schématiquement un exemple de procédé de stockage d'une application s'exécutant en machine virtuelle gérée par un hyperviseur de virtualisation, dans un système de stockage virtualisé qui est supporté par cet hyperviseur de virtualisation, selon l'art antérieur.
La figure 2 représente schématiquement un exemple de procédé de stockage d'une application s'exécutant en machine virtuelle gérée par un hyperviseur de virtualisation, dans un système de stockage virtualisé qui n'est pas supporté par cet hyperviseur de virtualisation, selon un mode de réalisation de l'invention.

### DESCRIPTION DETAILLEE DE L'INVENTION

La figure 1 représente schématiquement un exemple de procédé de stockage d'une application s'exécutant en machine virtuelle gérée par un hyperviseur de virtualisation, dans un système de stockage virtualisé qui est supporté par cet hyperviseur de virtualisation, selon un mode de réalisation de l'art antérieur.

Le système informatique comprend une partie application 1 et une partie stockage 2 qui communiquent sur une liaison 3 de communication. La partie application 1 comprend un empilement de plusieurs couches 10 à 14, la couche 13, par exemple «Windows Api Tape », étant au-dessus de la couche 14, par exemple « Driver Emulex Lpe 16002 », la couche 12, par exemple «Api Tape », étant au-dessus de la couche 13, la couche 11, par exemple « V7000 DIITape », étant au-dessus de la couche 12, la couche 10, par exemple « GCOS7 », étant au-dessus de la couche 11.

La partie stockage 2 comprend un empilement de plusieurs couches 21 à 24, la couche 23, par exemple « AIX », étant au-dessus de la couche 24, par exemple « Driver Target », la couche 22, gérant par exemple les commandes SCSI, étant au-dessus de la couche 23, la couche 21, par exemple « Moteur Virtuo », étant au-dessus de la couche 22. La couche 14 de la partie application 1 communique avec la couche 24 de la partie stockage 2 par la liaison 3. La liaison 3 est une connexion fibre véhiculant des commandes et des réponses SCSI.

Par exemple, une ou plusieurs applications 1 accède à des lecteurs de bandes 2 via une liaison 3 de type connexion fibre (« Fibre Channel »), permettant une connexion haut débit entre l'ordinateur hébergeant l'application 1 et le système de stockage 2. La liaison 3 transporte le protocole SCSI qui décrit les spécifications mécaniques, électriques et fonctionnelles du bus reliant un ordinateur à des périphériques.

La figure 2 représente schématiquement un exemple de procédé de stockage d'une application s'exécutant en machine virtuelle gérée par un hyperviseur de virtualisation, dans un système de stockage virtualisé qui n'est pas supporté par cet hyperviseur de virtualisation, selon un mode de réalisation de l'invention. Dans l'environnement virtualisé du système informatique de la figure 2, l'application ou les applications 1 et le système de stockage virtualisé 2 sont modifiés pour utiliser un protocole de communication réseau et non plus un protocole de communication de type connexion fibre.

Le système informatique comprend une partie application 1 et une partie stockage 2 qui communiquent par l'intermédiaire d'un protocole TCP/IP comprenant deux niveaux qui sont une liaison 4 réseau IP sur laquelle circulent les données stockées ainsi qu'une liaison 5 de commandes haut niveau TCP située au-dessus de la liaison 4.

La partie application 1 s'exécutant sur machine virtuelle comprend un empilement de plusieurs couches 10 à 13, la couche 12, par exemple « Api Tape », étant au-dessus de la couche 13, par exemple « Windows Socket », et comprenant une interface application 15, par exemple «New Interface Socket », la couche 11, par exemple « V7000 DIITape », étant au-dessus de la couche 12, la couche 10, par exemple « GCOS », étant au-dessus de la couche 11. La partie stockage virtualisé 2 comprend un empilement de plusieurs couches 21 à 23, la couche 22, gérant par exemple les commandes SCSI, étant au-dessus de la couche 23, par exemple « AIX », et comprenant une interface stockage 25, par exemple « New Interface Socket », la couche 21, par exemple «Moteur Virtuo », étant au-dessus de la couche 22. La couche 13 de la partie application 1 communique avec la couche 23 de la partie stockage virtualisé 2 par la liaison 4 sur laquelle circulent les données stockées et les données à stocker la liaison 5 qui permet l'échange de commandes haut niveau entre les interfaces application 15 et stockage 25. Ce sont ces interfaces, interface application 15 et interface stockage 25, qui permettent d'encapsuler et de décapsuler les commandes SCSI dans des trames IP transparentes pour l'hyperviseur de visualisation.

La couche 10 représente un exemple de système d'exploitation propriétaire GCOS7. Il permet d'exécuter une ou plusieurs applications 1 critiques et sécurisées, écrites principalement en langage de programmation COBOL. Le système GCOS7 tourne dans une machine virtuelle V7000 (« Virtualized 7000 » en langue anglaise) représentée par la couche 11, elle-même, s'exécutant sur un système « Microsoft Windows » (marque déposée) représenté par les couches 12 et 13. La machine virtuelle V7000 est l'émulation du micro-logiciel des plates-formes GCOS7 sur Windows (marque déposée). La machine virtuelle V7000 implémente l'ensemble des instructions de l'assembleur du système d'exploitation GCOS7 parmi lesquelles, le support du multiprocessus, la programmation des entrées et sorties, l'administration du système et les mécanismes de communications sur une architecture Intel (marque déposée).

L'application 1 est un produit basé sur la virtualisation de l'architecture GCOS7 composée du système « Microsoft Windows Server » (marque déposée) de la machine virtuelle V7000 et du système d'exploitation GCOS7. C'est donc une application virtualisée qui se présente sous la forme d'une machine virtuelle qui s'exécute sur l'hyperviseur de virtualisation « VMware ».

La ou les applications 1 s'exécutant dans GCOS7 ont la possibilité d'écrire sur des bandes gérées par le moteur Virtuo représenté par la couche 21. Le moteur Virtuo est un système de stockage virtualisé incluant un serveur, une grappe de disques et un logiciel capable d'émuler cet espace disque en bandes. Le moteur Virtuo s'exécute sur un dispositif AIX représenté par la couche 23. La couche 22 représente un système de commandes SCSI.

Une nouvelle communication TCP/IP est effectuée sur les liaisons 4 et 5, en remplacement de la liaison 3. Du côté de l'application 1, le nouveau protocole TCP/IP est implémenté au niveau de la machine virtuelle V7000. Il est transparent pour les applications 1 et le système d'exploitation GCOS7. Du côté du système de stockage virtualisé 2, le nouveau protocole s'appuyant sur TCP/IP est implémenté dans un module logiciel en amont des autres modules du système de stockage virtualisé 2 afin de limiter les impacts dans le moteur Virtuo.

Dans le cas de la figure 1, sur la liaison 3 de type connexion fibre, la communication s'appuyait sur un dispositif AIX de type PCI «Fibre Channel Target Adapter » attaché à une carte physique HBA Emulex. Dans le cas de la figure 2, sur les liaisons 4 et 5 avec le protocole TCP/IP, la communication s'appuie sur un dispositif AIX de type « Standard Ethernet Network Interface » attaché à une carte réseau.

Le chemin de données passe par la communication TCP/IP sur les liaisons 4 et 5. Le chemin de commandes, gérant les demandes de montage et démontage des bandes, demeure inchangé. La gestion de ces commandes est réalisée par une émulation de type ACSLS (« Automated Cartridge System Library Software » en langue anglaise) qui est un logiciel de serveur de stockage « Oracle Storage Tek ».

Bien entendu, la présente invention n'est pas limitée aux exemples et au mode de réalisation décrits et représentés, mais elle est susceptible de nombreuses variantes accessibles à l'homme de l'art.

## Revendications

1. Procédé de stockage de données d'une application (1) s'exécutant en machine virtuelle gérée par un hyperviseur de virtualisation, dans un système de stockage virtualisé (2) correspondant à l'émulation d'au moins un dispositif de stockage au moins partiellement non supporté par l'hyperviseur de virtualisation, par l'intermédiaire d'un protocole (4, 5) d'échange de données au niveau réseau qui d'une part n'est pas dédié au stockage de données et qui d'autre part est supporté par l'hyperviseur de virtualisation.

2. Procédé de stockage selon la revendication 1, **caractérisé en ce que** le dispositif de stockage émulé comprend l'émulation d'une ou de plusieurs mémoires à accès séquentiel pour la lecture et pour l'écriture.

3. Procédé de stockage selon la revendication 1 ou 2, **caractérisé en ce que** le dispositif de stockage émulé comprend l'émulation d'une ou de plusieurs mémoires amovibles.

4. Procédé de stockage selon la revendication 3, **caractérisé en ce que** le dispositif de stockage émulé comprend l'émulation d'au moins une bande magnétique et d'au moins un lecteur de bandes magnétiques associé.

5. Procédé de stockage selon l'une quelconque des revendications précédentes, **caractérisé en ce que** le protocole (4, 5) d'échange de données au niveau réseau est TCP/IP.

6. Procédé de stockage de données d'une application (1) s'exécutant en machine virtuelle, dans un système de stockage virtualisé (2) correspondant à l'émulation d'au moins une bande magnétique et d'au moins un lecteur de bandes magnétiques associé, par l'intermédiaire d'un protocole d'échange de données (4, 5) qui est TCP/IP.

7. Procédé de stockage selon la revendication 5 ou 6, **caractérisé en ce que** le protocole (4, 5) de communication TCP/IP simule des commandes SCSI et leurs réponses.

8. Procédé de stockage selon l'une quelconque des revendications précédentes, **caractérisé en ce que** le dispositif de stockage émulé écoute les requêtes de la ou des applications (1) au niveau d'un point de communication (25) défini par l'association d'une adresse IP et d'un numéro de port.

9. Procédé de stockage selon l'une quelconque des revendications précédentes, **caractérisé en ce que** l'application (1) est une application critique sécurisée requérant une sauvegarde dynamique.

10. Procédé de stockage selon l'une quelconque des revendications précédentes, **caractérisé en ce que** la gestion du dispositif de stockage émulé lui-même est effectuée à l'aide d'un protocole de communication qui d'une part est différent du protocole d'échange de données (4, 5) au niveau réseau et d'autre part n'est pas dédié au stockage de données.

11. Procédé de stockage selon l'une quelconque des revendications précédentes, **caractérisé en ce que** la machine virtuelle est basée sur la virtualisation d'un système d'exploitation propriétaire.

12. Procédé de stockage selon l'une quelconque des revendications précédentes, **caractérisé en ce que** l'hyperviseur de virtualisation est un hyperviseur de virtualisation VMware.

13. Procédé de stockage selon l'une quelconque des revendications précédentes, **caractérisé en ce que** le moteur du système de stockage virtualisé (2) s'exécute sur une plateforme AIX.

14. Machine virtuelle gérée par un hyperviseur de virtualisation, comprenant une interface machine (15) codée de manière d'une part à envoyer des commandes de stockage de données d'une application (1) s'exécutant sur cette machine virtuelle et d'autre part à recevoir des réponses à ces commandes de la part d'un système de stockage virtualisé (2) correspondant à l'émulation d'au moins un dispositif de stockage au moins partiellement non supporté par l'hyperviseur de virtualisation, par l'intermédiaire d'un protocole d'échange de données (4, 5) au niveau réseau qui d'une part n'est pas dédié au stockage de données et qui d'autre part est supporté par l'hyperviseur de virtualisation.

15. Système de stockage virtualisé (2) correspondant à l'émulation d'au moins un dispositif de stockage au moins partiellement non supporté par un hyperviseur de virtualisation, comprenant une interface stockage (25) codée de manière d'une part à recevoir des commandes de stockage de données d'une application (1) s'exécutant sur une machine virtuelle gérée par cet hyperviseur de virtualisation et d'autre part à envoyer des réponses à ces commandes, par l'intermédiaire d'un protocole d'échange de données (4, 5) au niveau réseau qui d'une part n'est pas dédié au stockage de données et qui d'autre part est supporté par cet hyperviseur de virtualisation.

16. Système de stockage virtualisé selon la revendication 15, **caractérisé en ce qu'**il comprend un serveur associé à une grappe de disques et à un logiciel d'émulation de l'espace disque de la grappe de disques en au moins une bande magnétique virtuelle et en au moins un lecteur de bandes magnétiques associé virtuel, et de préférence **en ce que** le lecteur de bandes magnétiques virtuel est un lecteur LTO5 HP.
